Europäisches Patentamt

European Patent Office

Office européen des brevets

(19)

(11) Veröffentlichungsnummer: **0 386 009 B1**

# EUROPÄISCHE PATENTSCHRIFT

(12)

(45) Veröffentlichungstag der Patentschrift: **28.04.93**

(51) Int. Cl.⁵: **H03H 9/145**

(21) Anmeldenummer: **88907630.3**

(22) Anmeldetag: **19.09.88**

(86) Internationale Anmeldenummer:
**PCT/DE88/00584**

(87) Internationale Veröffentlichungsnummer:
**WO 89/02675 (23.03.89 89/07)**

(54) **OBERFLÄCHENWELLENANORDNUNG MIT KONVERSIONSSTRUKTUR ZUR VERMEIDUNG UNERWÜNSCHTER REFLEKTIERTER WELLEN.**

(30) Priorität: **17.09.87 DE 3731309**

(43) Veröffentlichungstag der Anmeldung:
**12.09.90 Patentblatt 90/37**

(45) Bekanntmachung des Hinweises auf die Patenterteilung:
**28.04.93 Patentblatt 93/17**

(84) Benannte Vertragsstaaten:
**DE FR GB**

(56) Entgegenhaltungen:
**DE-A- 3 544 132**
**DE-A- 3 700 789**
**US-A- 4 623 855**

(73) Patentinhaber: **SIEMENS AKTIENGESELL-SCHAFT**
**Wittelsbacherplatz 2**
**W-8000 München 2(DE)**

(72) Erfinder: **FLEISCHMANN, Bernd**
**Von-Frays-Str. 9**
**W-8000 München 60(DE)**
Erfinder: **RIHA, Gerd**
**Lerchenauerstr. 19**
**W-8000 München 40(DE)**

EP 0 386 009 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 386 009 B1

**Beschreibung**

Die vorliegende Erfindung bezieht sich auf eine Oberflächenwellenanordnung nach dem Oberbegriff des Patentanspruches 1.

Oberflächenwellenanordnungen mit Wandler- und/oder Reflektorstrukturen auf piezoelektrischem Substratkörper sind hinlänglich bekannt.

Es ist üblich, zur Vermeidung von Störungen, hervorgerufen durch an den Kanten des Substratkörpers reflektierten Oberflächenwellen, die Kanten bzw. Stirnflächen des Substratkörpers und die diesen Kanten benachbarten Oberflächenbereiche desselben mit einem akustisch unelastischen, d.h. dämpfenden Material, zu beschichten. Ein solches Material dient als Sumpf für Oberflächenwellen. In einen solchen Sumpf hineinlaufende Oberflächenwellen werden dort absorbierend gedämpft und werden insbesondere nicht wieder reflektiert. Dieser Wegfall einer Reflexion bewirkt, daß die gewollte Oberflächenwellen-Ausbreitung in vorgesehener Weise erfolgt.

Obwohl diese Methode vom Standpunkt der Wellenausbreitung gesehen ein an sich zufriedenstellendes Ergebnis liefert, sind mit einer solchen Maßnahme dennoch Nachteile verbunden. Das Material für einen solchen Sumpf ist in der Regel organisches Material, das nicht frei von Kontaminationswirkung auf die übrige Substratoberfläche ist. Selbst geringe Kontaminationen der Substratoberfläche im Bereich der vorgesehenen Oberflächenwellenausbreitung kann aber zu ganz gravierenden Störungen führen, und zwar insbesondere deshalb, weil zum einen ein solcher Sumpf eine relativ große Oberfläche eines solchen organischen Materials darstellt und zum anderen dieses Material dicht benachbart den kontaminationsfrei zu haltenden Oberflächenbereichen des Substratkörpers ist.

Es ist Aufgabe der vorliegenden Erfindung, eine neue Maßnahme zu finden, mit der das durch Reflexion von Oberflächenwellen an Substratkanten an sich mögliche Entstehen reflektierter Oberflächenwellen in Oberflächenbereichen des Substratkörpers, wo das Auftreten von Oberflächenwellen an sich nicht erwünscht ist, zu vermeiden ist.

Diese Aufgabe wird mit den Merkmalen des Patentanspruches 1 gelöst und weitere Ausgestaltungen und Weiterbildungen der Erfindung gehen aus den Unteransprüchen hervor.

Der vorliegenden Erfindung liegt der Gedanke zugrunde, wenigstens nach Möglichkeit die an sich bekannte Verwendung eines Sumpfes aus organischem Material zu vermeiden oder zumindest die nach dem Stand der Technik zur Erzielung dieser Wirkung bekanntermaßen verwendete Menge solchen Materials ganz erheblich zu vermindern. Die dazu angestellten Überlegungen führten zu dem Gedanken, bereits von einem ganz anderen Prinzip auszugehen. Das der Erfindung zugrundeliegende andere Pinzip ist, anstelle der unelastischen Störung solcher Oberflächenwellen im Prinzip das Gegenteil vorzusehen, nämlich elastische Störung solcher Wellen auszunutzen, jedoch mit dem Zusatz, eine solche unerwünschte Oberflächenwelle in eine andere Form zu konvertieren. Vorzugsweise ist dies die Form der Volumenwelle. Das Auftreten von Volumenwellen ist jedoch an sich äußerst unerwünscht und bei der vorliegenden Erfindung sind die Maßnahmen so getroffen, daß die mit der Konversion bewußt erzeugten Volumenwellen im Substratkörper eine solche Richtung bzw. eine solche Ausbreitung annehmen, daß sie für den wirksamen Oberflächenwellen-Ausbreitungsbereich der Wandler- und/oder Reflektorstrukturen keinen Nachteil hervorrufen können. Insbesondere ist dazu vorgesehen, die in Volumenwellen konvertierten Oberflächenwellen als solche Volumenwellen in einem derartigen Winkel von der Substratoberfläche weggerichtet verlaufen zu lassen, daß diese Volumenwellen insbesondere in den Bereich des unelastisch dämpfenden Klebstoffes gelangen, mit dem der Substratkörper üblicherweise an der Unterlage bzw. im Gehäuse befestigt ist.

Der Hinweis auf diesen Klebstoff ist ein nur scheinbarer Widerspruch zu den obigen Ausführungen zu dem organischen Material eines Sumpfes. Solches den Substratkörper mit der Unterlage verbindendes Klebstoffmaterial befindet sich zum einen ausschließlich auf der Rückseite des Substratkörpers. Nahezu das gesamte Klebstoffmaterial ist durch diese rückseitige Oberfläche des Substratkörpers und die Auflagefläche im Gehäuse diffusionsdicht abgedeckt. Einzig und allein die außerordentlich schmalen Ränder stehen mit der Gehäuse-Innenatmosphäre in direktem Kontakt.

Die voranstehenden Ausführungen sind aber kein Widerspruch zu der zu bevorzugenden Ausführungsform, bei der der Substratkörper mittels anderer Verbindung als der Verwendung eines Klebstoffes im Gehäuse gehaltert ist. In einem solchen Falle verläuft die Energie der Volumenwelle in dem Substratkörper und verliert ihre Energie bei vielfachen Reflexionen an dessen Begrenzungsflächen. Auch damit wird das Ziel der Erfindung erreicht.

Eine erfindungsgemäß angewendete Konversionsstruktur ist z.B. eine auf der Oberfläche des Substratkörpers, nämlich in den Oberflächenbereichen, in denen das Auftreten von Oberflächenwellen an sich ohnehin unerwünscht ist, erhabene Struktur. Diese Struktur kann z.B. aus auf die Oberfläche aufgebrachtem Material wie Metall, jedoch auch Siliziumdioxid und ähnlicher Stoff, sein. Im Gegensatz dazu können auch vertiefte, z.B. eingeätzte Strukturen als Oberflächenstörung des Substratkörpers vorgesehen sein. Vorzugsweise besteht eine solche Konversionsstruktur aus Fingerstreifen, z.B. aus Metall, wie sie z.B. für Reflektorstrukturen einer Oberflächenwellenanordnung benutzt werden. Im wesentlichen läßt man solche Streifen orthogonal oder schräg zur Wellenausbreitungsrichtung der Oberflächenweilen in der Wandler- und/oder Reflektorstruktur verlaufen. Solche Streifen können auch gekrümmt sein. Es bedarf auch nicht zwingend eines durchgehenden Streifens. Vielmehr können die einzelnen Streifen Unterbrechungen aufweisen, so daß solche Streifen z.B. in dots aufgelöste linienförmige Strukturen sind. Die Streifen selbst können äquidistant, periodisch verteilt und/oder gemäß einer Zufallsverteilung verteilt angeordnet sein. Äquidistante Verteilung ist leicht übersichtlich. Periodische Verteilung hat den Vorzug der Übersichtlichkeit eines erfaßten Frequenzbereiches zu bieten. Zufallsverteilung begünstigt die Vermeidung von unerwünschterweise auftretenden singulären Stellen.

Zum Begriff einer "Konversionsstruktur" ist noch die Druckschrift US-A-4 268 808 zu erwähnen. Die dort beschriebene, mit akustischen Wellen arbeitende Anordnung verwendet Konversionsstrukturen zur Umwandlung von Oberflächenwellen in im Volumen des Substrats laufende BAW-plate mode-Wellen und zur Rückumwandlung dieser Wellen in Oberflächenwellen. Die für das Filter dieser Druckschrift verwendeten Konversionsstrukturen sind jedoch für die Filterfunktion notwendige Bestandteile dieser Anordnung, das heißt ohne diese Strukturen ist das Filter der US-A-4 268 808 in keiner Weise mehr bestimmungsgemäß funktionsfähig. Die Konversionsstrukturen müssen dort notwendigerweise im Weg der akustischen Wellen des Filter zwischen dem (Oberflächenwellen-)Eingangswandler und dem Ausgangswandler angeordnet sein. Bei der Erfindung darf dies jedoch gerade nicht der Fall sein, sondern die erfindungsgemäß jeweils verwendete Konversionsstruktur muß erstens außerhalb des gegenseitigen Wirkungsbereichs von Eingangswandler und Ausgangswandler, nämlich in einem solchen Bereich des Substrats angeordnet sein, in dem das Auftreten der (funktionswesentlichen) Oberflächenwellen unerwünscht ist, und darf zweitens nur für solche Oberflächenwellenanteile wirksam sein, die ansonsten durch einen Sumpf oder dergleichen als unerwünscht zu eliminieren sind.

Weitere Erläuterungen gehen aus der nachfolgenden Beschreibung zu Figuren für Ausführungsbeispiele der Erfindung hervor.

Nach weiterer Erläuterung gehen aus der nachfolgenden Beschreibung zu Figuren vier Ausführungsbeispiele der Erfindung hervor.

Figur 1 zeigt eine erste Ausführungsform einer erfindungsgemäßen Oberflächenwellenanordnung mit einer ersten Art einer Konversionsstruktur,

Figur 2 zeigt eine zweite Ausführungsform mit einer zweiten Art einer Konversionsstruktur,

Figur 3 zeigt eine dritte Ausführungsform mit einer dritten Art einer Konversionsstruktur und

Figur 4 zeigt eine Prinzipdarstellung zur weiteren Erläuterung.

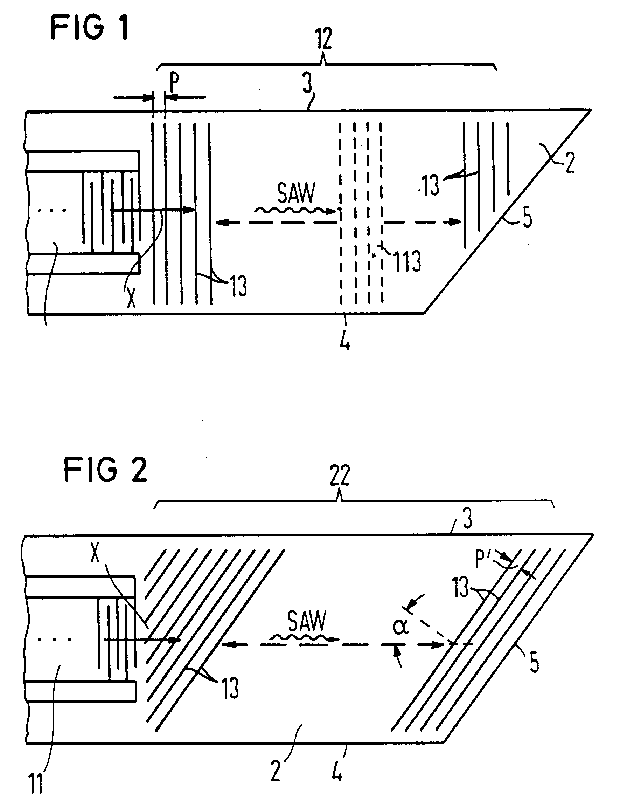

In Figur 1 ist mit 2 der übliche Substratkörper einer Oberflächenwellenanordnung bezeichnet. Dieser Substratkörper 2 besitzt die seitlichen Flächen 3 und 4 und die wie üblich abgeschrägt ausgebildete endständige Stirnfläche 5. Von diesen Flächen 3, 4 und 5 sind jeweils nur die Kanten am Rande der Oberfläche des Substratkörpers 2 in der Aufsicht der Figur 1 zu sehen. Mit 11 ist eine auf dem Substratkörper vorhandene übliche Wandlerstruktur bezeichnet, und zwar diejenige Wandlerstruktur, die dem in der Figur 1 dargestellten rechten Ende des Substratkörpers am nächsten ist. Eine in der angegebenen Richtung x aus dem Wandler 11 auf die Stirnfläche 5 zulaufende Oberflächenwelle SAW würde Reflexion an diesem Ende des Substratkörpers 2 erfahren. Durch die Schrägrichtung der Stirnfläche 5 wird zwar der Störeinfluß der Reflexion stark minimiert, jedoch durch Vielfachreflexionen gelangt dennoch ein gewisser Anteil in Richtung x aus dem Wandler 11 ausgetretene Oberflächenwellenenergie in die Oberflächenwellenanordnung wieder zurück.

Erfindungsgemäß ist die Konversionsstruktur 12 vorgesehen, die wie dargestellt, streifenförmig ausgeführt ist und aus für die akustische Oberflächenwelle SAW wirksamen Störungen in/auf der Oberfläche des Substratkörpers 2 besteht. Zum Beispiel können diese Streifen 13 Metallisierungsstreifen sein, wie sie auch für die Finger des Wandlers 11 verwendet werden. Es können dies aber auch Streifen 13 aus aufgebrachtem Siliziumdioxid, Aluminiumoxid und dgl. sein. Anstelle solcher auf der Oberfläche erhabener Strukturen können solche Streifen auch in die Oberfläche des Substratkörpers 2 eingeätzte Rillen, Gräben oder dgl. sein. Eine solche Konversionsstruktur 12 besteht aus einer Vielzahl benachbart im Abstand voneinander, nebeneinander verlaufender Streifen, obwohl in der Figur 1 nur eine Anzahl solcher Streifen dargestellt sind. Mit 113 ist eine besondere Streifenform angedeutet, die aus derart in Längsrichtung unterbrochenen Streifen besteht, daß solche Streifen in wie dargestellten Folgen von dots aufgelöst ist. Insbesondere können diese dots in Richtung der Streifen, und zwar benachbarte Streifen miteinander verglichen, gegeneinander verteilt angeordnet sein.

Bei der Ausführungsform nach Figur 1 sind die Streifen 13, 113 im wesentlichen orthogonal zur Ausbreitungsrichtung x der Oberflächenwelle SAW ausgerichtet.

Die Figur 2 zeigt eine der Figur 1 ähnliche Ausführungsform mit Bezugszeichen, die soweit sie schon zur Figur 1 beschrieben sind, auch in Figur 2 die gleiche Bedeutung haben. Die Konversionsstruktur 22 besteht bei der Ausführungsform nach Figur 2 aus Streifen 13, die hier jedoch schräg zur Wellenausbreitungsrichtung x orientiert sind. Auch für die Ausführungsform nach Figur 2 können diese Streifen durch dot-Folgen 113 realisiert sein.

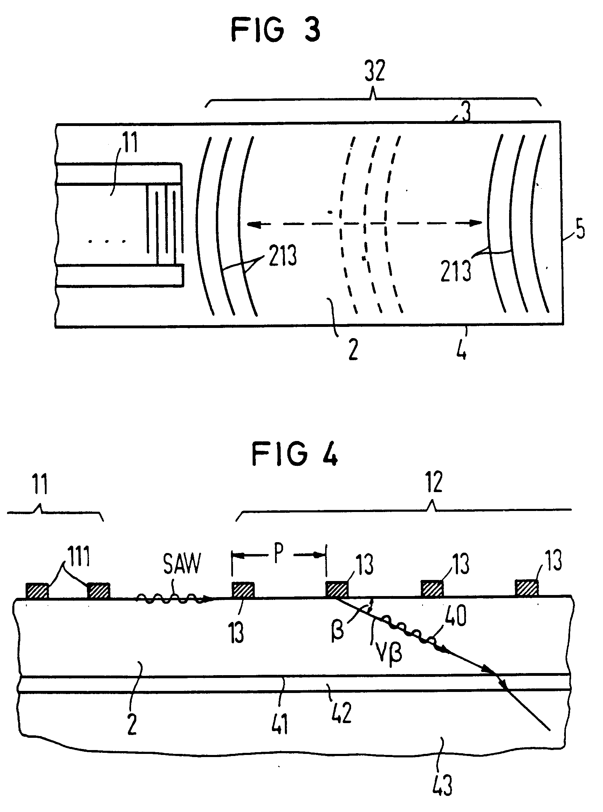

Die Figur 3 zeigt eine weitere Ausführungsform mit gekrümmt ausgeführten Streifen 213 der Konversionsstruktur 32. Auch die Konversionsstruktur 32 kann aus jeweiligen dot-Folgen bestehen, wie dies bereits zu den vorangehenden Ausführungsformen erläutert ist.

Die Figur 4 dient dazu, dem Fachmann die Dimensionierung einer erfindungsgemäß vorgesehenen Konversionsstruktur zu erleichtern.

Die Figur 4 ist eine Seitenansicht, in der die erhabenen Streifen 13, z.B. Metallisierungsstreifen, im Querschnitt dargestellt sind. Zwei Finger 111 der Wandlerstruktur 11 sind zusätzlich dargestellt.

Eine aus dem Wandler 11 in der Oberfläche in Richtung x verlaufende Oberflächenwelle SAW wird durch die Streifen 13 der Konversionsstruktur 12 gestört. Man kann sich diese Störung so vorstellen, daß an jeweils einer Kante H eines jeden Streifens 13 eine Zylinderwelle in den den unteren Halbraum bildenden Substratkörper 2 ausgesandt wird. Aufgrund der Längserstreckung der Streifen 13 ergibt sich eine Zylindersymmetrie für eine solche Wellenerzeugung. Eine solche Wellenerzeugung erfolgt an jedem einzelnen Streifen 13. Bei angenommen äquidistanter Periodizität P der Anordnung der Streifen 13 auf der Oberfläche des Substratkörpers 2 ergibt sich ein Interferenzverhalten der an den Kanten der jeweiligen Streifen 13 gestörten Oberflächenwelle, so daß eine Welle entsteht, die durch den Vektor $v_\beta$ repräsentiert ist. Bei einer solchen mit 40 angedeuteten Welle handelt es sich um eine Volumenwelle im Substratkörper 2, die von der Oberflächenwelle SAW, nämlich wegen des Vorhandenseins dieser Oberflächenstörungen, erzeugt worden ist. Die Energie dieser Volumenwelle 40 rührt aus der Energie der SAW-Welle her, so daß die SAW-Welle entsprechend der erfindungsgemäß vorgesehenen Konversion zum Verschwinden gebracht werden kann.

Man sieht, daß in den von den Konversionsstrukturen 12, 22, 32 eingenommenen Bereichen, in denen bei der jeweiligen Oberflächenwellenanordnung das Auftreten einer Oberflächenwelle SAW an sich unerwünscht ist, die Energie dieser Oberflächenwelle erfindungsgemäß in die Energie einer Volumenwelle transformiert wird. Entsprechend dem bei der Erfindung genutzten Interferenzprinzip erhält man optimale Konversion dann, wenn die Abmessung der Periodizität P angepaßt ist. Hierfür ist die nachfolgende Gleichung

$$\frac{1}{P \cdot f} \quad kleiner \quad \frac{1}{v_{SAW}} \quad + \quad \frac{1}{v^*}$$

die Basis, worin f die jeweils unteren Frequenzgrenze des vorgesehenen Übertragungsbandes der betreffenden Oberflächenwellenanordnung ist, worin $v_{SAW}$ die Geschwindigkeit der Oberflächenwelle SAW im Material des Substratkörpers ist und $v^*$ eine Geschwindigkeit der Volumenwelle ist, und zwar als $V_{max}$ desjenigen Wellenmodes, der die höchste Schallgeschwindigkeit im Material des Substratkörpers 2 hat oder als $V_{BAW}$, nämlich der Geschwindigkeit der langsamsten Volumenwelle (Bulk Acoustic Wave), die maßgeblich zur Oberflächenwelle SAW beiträgt. Wird in der Anordnung als Oberflächenwelle eine Rayleigh-Welle angeregt, so ist für die Geschwindigkeit $V_{BAW}$ der Geschwindigkeitswert der vertikal polarisierten (Quasi-) Scherwelle einzusetzen. Ist die angeregte Oberflächenwelle eine horizontal polarisierte Oberflächenscherwelle, so ist für die Geschwindigkeit $V_{BAW}$ der Geschwindigkeitswert der horizontal polarisierten Volumenscherwelle einzusetzen. Eine mit der Geschwindigkeit $V_{BAW}$ bemessene, erfindungsgemäß verwendete Konversionsstruktur ermöglicht, maximale Dämpfung pro Wellenlänge bzw. optimale Vermeidung des Auftretens ansonsten an den Kanten des Substratkörpers reflektierter Oberflächenwellen zu erreichen. Mit einer mit $V_{max}$ dimensionierten Konversionsstruktur der Erfindung erreicht man zwar nicht ganz die optimalen Dämpfungswerte, diese Konversionsstruktur ist dafür aber in sich reflexionsärmer.

Für schräggestellte Streifen der Konversionsstruktur, nämlich wie sie bei einer Ausführungsform nach Figur 2 vorgesehen sind, ist die Bemessung des wie in Figur 1 in Richtung der Wellen-Hauptfortpflanzungsrichtung gemessenen Abstandes entsprechend dem Winkel $\alpha$ zwischen der Wellen-Hauptfortpflanzungsrichtung x und der normalen Richtung der schräggestellten Streifen der Konversionsstruktur zu transponieren, so daß sich ergibt p . cos $\alpha$ = p'. Damit ergibt sich entsprechend die transponierte Gleichung

4

$$\frac{1}{p \cdot \cos\alpha \cdot f} = \frac{1}{p' \cdot f} \quad kleiner \quad \frac{1}{V_{SAW}} + \frac{1}{V^*} \cdot K$$

mit $V^* = V_{BAW}$ bzw. $= V_{max}$.

Der in dieser Gleichung enthaltene Korrekturfaktor ergibt sich aus der vektoriellen Addition des Wellenzahlvektors $k_{SAW}$ (der proportional der reziproken Geschwindigkeit $1/V_{SAW}$ ist) und dem Wellenzahlvektor k der betreffenden Volumenwelle. Der Vektor $k_{SAW}$ hat weiterhin die Richtung der Wellen-Hauptfortpflanzungsrichtung x. Diese Addition hat die Vektorsumme

$$\vec{k}_{Go} = \vec{k}_{SAW} + \vec{k}_{(Volumenwelle)} \quad ,$$

worin die Vektorrichtung für $k_{Go}$ gleich der zu den nach Figur 3 mit Winkel $\alpha$ schräggestellten Streifen orthogonalen Richtung ist. Es ergibt sich daraus folgend der Korrekturfaktor

$$K = \left[ 1 + \tan^2 \alpha \left( 1 - \frac{V^{*2}}{V^2_{SAW}} \right) \right]^{1/2} \quad ,$$

der für $\alpha$ gleich 0 ebenso wie cos $\alpha$ den Wert gleich 1 hat und der für kleinere Winkel insbesondere dann unbeachtet bleiben kann, wenn man sich hinsichtlich der Bemessung für p mit "kleiner" dem Optimum bei "gleich" nicht besonders genähert hat.

Die Figur 4 zeigt wie eine Volumenwelle 40 im Winkel $\beta$ zur Oberfläche durch den Substratkörper 2 zu der unteren Oberfläche 41 des an sich relativ dünnen Substratkörpers 2 gelangt. Von dort kann ein Energieanteil der Volumenwelle 40 in die Klebstoffschicht 42 gelangen, mit der der Substratkörper 2 auf der Unterlage 43 des Gehäuses angeklebt ist. Eine Ausgestaltung der Erfindung ist, äquidistante Abmessung P vorzusehen. Wie gesagt handelt es sich dabei um eine Struktur 12, die unter Berücksichtigung des Winkels $\beta$ der Periodizität der Wellenausbreitung der Volumenwelle 40 entspricht, und zwar der Welle 40 mit derjenigen Frequenz f, die durch die SAW-Welle der Wandlerstruktur 11 vorgegeben ist.

Es kann von Vorteil sein, anstelle äquidistanter Abmessung P hierfür solche Werte zu nehmen, die zwar nahe dem Wert P liegen, die aber einer periodischen Verteilung entsprechen, die um den errechneten Wert P herum liegen. Es handelt sich sozusagen um eine Modulation des errechneten Wertes p. Von Bedeutung ist eine solche Maßnahme insbesondere für breitbandigere Oberflächenwellenanordnungen. Anstelle einer periodischen Verteilung einer solchen "Modulation" können die Werte P ± dP auch gemäß einer Zufallsverteilung verteilt sein.

**Patentansprüche**

1. Oberflächenwellenanordnung
   mit einem piezoelektrischen Substratkörper (2), der mit seiner einen Oberfläche mittels einer Klebstoffschicht (42) an einer Unterlage angeklebt ist,
   mit auf der zweiten Oberfläche dieses Substratkörpers (2) vorgesehenen wenigstens zwei aus Fingerstreifen bestehenden Wandlern zur Erzeugung von Oberflächenwellen eines vorgegebenen Typs und ggf. wenigstens einer aus Reflektorstreifen bestehenden Reflektorstruktur, die auf den Erhalt des vorgegebenen Wellentyps abgestimmt ist, wobei die Wandler die Wellen-Hauptfortpflanzungsrichtung (x) bestimmen, und
   mit dazu weiterer Maßnahme zur Vermeidung des Auftretens ansonsten an den betreffenden Kanten des Substratkörpers reflektierter Oberflächenwellen,
   **gekennzeichnet dadurch,**
   daß als solche weitere Maßnahme eine den erzeugten vorgegebenen Wellentyp umwandelnde Konversionsstruktur (12, 22, 32) vorgesehen ist, die, gesehen in Richtung der Wellen-Hauptausbreitungsrichtung (x), in einem solchen Bereich dieser zweiten Oberfläche des Substratkörpers angeordnet ist, in dem das Auftreten einer Oberflächenwelle unerwünscht ist, wobei diese Konversionsstruktur (12, 22, 32) als für akustische Wellen wirksame Störung aus einer Anzahl in/auf der Oberfläche des Substratkörpers (2) vorgesehenen, benachbart im Abstand (P) voneinander nebeneinander verlaufenden Streifen (13, 113) besteht und, gemessen in der Wellen-Hauptausbreitungsrichtung, die Periodizität (P) der Streifen (13, 113, 213) entsprechend der Gleichung bemessen ist:

$$\frac{1}{P \cdot f} \quad \text{kleiner als} \quad \frac{1}{V_{SAW}} \quad + \quad \frac{1}{V^*}$$

worin f die jeweils untere Frequenzgrenze des vorgesehenen Übertragungsbandes der betreffenden Oberflächenwellenanordnung ist, worin $V_{SAW}$ die Geschwindigkeit der Oberflächenwelle (SAW) des vorgegebenen Wellentyps im Material des Substratkörpers (2) ist und $V^*$ die Geschwindigkeit ($V_{max}$) derjenigen durch Umwandlung entstandenen Volumenwelle ist, die die Volumenwelle desjenigen Wellenmodes ist, der die höchste Schallgeschwindigkeit ($V_{max}$) im Material des Substratkörpers (2) hat, oder die Geschwindigkeit ($V_{BAW}$) derjenigen durch Umwandlung entstandenen Volumenwelle ist, die die langsamste der Volumenwellen ist, die maßgeblich zur Oberflächenwelle (SAW) des vorgegebenen Wellentyps beiträgt, so daß die aus unerwünschterweise auftretenden Oberflächenwellen in der Konversionsstruktur (12) erzeugten Volumenwellen (40) in den Bereich des unelastisch dämpfenden Klebstoffs (42) gelangen.

2. Oberflächenwellenanordnung nach Anspruch 1,
**gekennzeichnet dadurch,**
daß bei Anregung einer Oberflächenwelle (SAW) des Typs Rayleigh-Welle die Geschwindigkeit ($V_{BAW}$) die Geschwindigkeit der vertikal polarisierten (Quasi-) Scherwelle ist.

3. Oberflächenwellenanordnung nach Anspruch 1,
**gekennzeichnet dadurch,**
daß bei Anregung einer Oberflächenwelle (SAW) des Typs Rayleigh-Welle die Geschwindigkeit ($V_{BAW}$) die Geschwindigkeit der horizontal polarisierten Volumenscherwelle ist.

4. Oberflächenwellenanordnung nach Anspruch 1, 2 oder 3,
**gekennzeichnet dadurch,**
daß die Konversionsstruktur (12, 22, 32) aus auf die Oberfläche des Substratkörpers strukturiert aufgebrachtem Material besteht.

5. Oberflächenwellenanordnung nach Anspruch 4,
**gekennzeichnet dadurch,**
daß dieses Material elektrisch nichtleitend ist.

6. Oberflächenwellenanordnung nach Anspruch 4 oder 5,
**gekennzeichnet dadurch,**
daß dieses Material ein Metalloxid ist.

7. Oberflächenwellenanordnung nach Anspruch 4,
**gekennzeichnet dadurch,**
daß das Material Metall ist.

8. Oberflächenwellenanordnung nach Anspruch 1, oder 3,
**gekennzeichnet dadurch,**
daß die Konversionsstruktur eine in die Oberfläche eingearbeitete, vertiefte Struktur ist.

9. Oberflächenwellenanordnung nach Anspruch 8,
**gekennzeichnet dadurch,**
daß die vertiefte Struktur eine Ätzstruktur ist.

**10.** Oberflächenwellenanordnung nach Anspruch 9,
**gekennzeichnet dadurch,**
daß die Streifen im wesentlichen orthogonal zur Wellen-Hauptfortpflanzungsrichtungder Wandler- und/oder Reflektorstruktur ausgerichtet sind.

**11.** Oberflächenwellenanordnung nach Anspruch 9,
**gekennzeichnet dadurch,**
daß die Streifen im wesentlichen schräg zur Wellen-Hauptfortpflanzungsrichtung der Wandler- und/oder Reflektorstruktur ausgerichtet sind.

**12.** Oberflächenwellenordnung nach einem der Ansprüche 1 bis 9,
**gekennzeichnet dadurch,**
daß die Streifen (213) gekrümmt verlaufende Form besitzen.

**13.** Oberflächenwellenanordnung nach Anspruch 9, 10 oder 11,
**gekennzeichnet dadurch,**
daß die Streifen (113) Unterbrechungen haben, so daß in Streifenrichtung aufeinanderfolgend dots vorhanden sind.

**14.** Oberflächenwellenanordnung nach einem der Ansprüche 9 bis 12,
**gekennzeichnet dadurch,**
daß die Streifen äquidistant zueinander angeordnet sind.

**Claims**

**1.** Surface wave arrangement with a piezoelectric substrate body (2) which is bonded with its one surface to a support by means of an adhesive layer (42), with at least two converters, which are provided on the second surface of this substrate body (2) and comprise finger strips, for generating surface waves of a predetermined type and, as the case may be, at least one reflector structure comprising reflector strips which is tuned to receive the predetermined wave type, the converters determining the principal direction of wave propagation (x), and with a measure further thereto for avoiding the occurrence of surface waves otherwise reflected at the relevant edges of the substrate body, characterised in that there is provided as such a further measure a conversion structure (12, 22, 32) which converts the predetermined wave-type generated and, seen in the direction of the principal direction of wave propagation (x), is arranged in such a region of this second surface of the substrate body in which the occurrence of a surface wave is undesirable, this conversion structure (12, 22, 32) comprising, as a disturbance effective for acoustic waves, a number of strips (13, 113) which are provided in/on the surface of the substrate body (2) and run next to one another adjacent at an interval (P) from one another, and, measured in the principal direction of wave propagation, the periodicity (P) of the strips (13, 113, 213) being dimensioned according to the equation:

$$\frac{1}{P.f} \text{ less than } \frac{1}{V_{SAW}} + \frac{1}{V^*},$$

where f is the particular lower frequency limit of the provided transmission band of the relevant surface wave arrangement, where $V_{SAW}$ is the velocity of the surface wave (SAW) of the predetermined wave type in the material of the substrate body (2), and $V^*$ is the velocity ($V_{max}$) of that bulk wave arising by conversion which is the bulk wave of that wave mode which has the highest sound velocity ($V_{max}$) in the material of the substrate body (2), or is the velocity ($V_{BAW}$) of that bulk wave arising by conversion which is the slowest of the bulk waves which contributes substantially to the surface wave (SAW) of the predetermined wave type, so that the bulk waves (40) generated from surface waves occurring undesirably in the conversion structure pass into the region of the inelastically damping adhesive (42).

**2.** Surface wave arrangement according to Claim 1, characterised in that in the case of excitation of a surface wave (SAW) of the type of a Rayleigh wave, the velocity ($V_{BAW}$) is the velocity of the vertically polarized (quasi) shear wave.

EP 0 386 009 B1

**3.** Surface wave arrangement according to Claim 1, characterised in that in the case of excitation of a surface wave (SAW) of the type of a Rayleigh wave, the velocity ($V_{BAW}$) is the velocity of the horizontally polarized shear bulk wave.

**4.** Surface wave arrangement according to Claim 1, 2 or 3, characterised in that the conversion structure (12, 22, 32) consists of material applied in a structured fashion to the surface of the substrate body.

**5.** Surface wave arrangement according to Claim 4, characterised in that this material is electrically non-conductive.

**6.** Surface wave arrangement according to Claim 4 or 5, characterised in that this material is a metal oxide.

**7.** Surface wave arrangement according to Claim 4, characterised in that the material is metal.

**8.** Surface wave arrangement according to Claim 1 or 3, characterised in that the conversion structure is a sunken structure worked into the surface.

**9.** Surface wave arrangement according to Claim 8, characterised in that the sunken structure is an etched structure.

**10.** Surface wave arrangement according to Claim 9, characterised in that the strips are aligned essentially orthogonal to the principal direction of wave propagation of the converter and/or reflector structure.

**11.** Surface wave arrangement according to Claim 9, characterised in that the strips are aligned essentially at a slant to the principal direction of wave propagation of the converter and/or reflector structure.

**12.** Surface wave arrangement according to one of Claims 1 to 9, characterised in that the strips (213) possess a form which runs curved.

**13.** Surface wave arrangement according to Claim 9, 10 or 11, characterised in that the strips (113) have interruptions, so that dots are present sequentially in the strip direction.

**14.** Surface wave arrangement according to one of Claims 9 to 12, characterised in that the strips are arranged equidistant from one another.

**Revendications**

**1.** Dispositif à ondes de surface comportant

un substrat (2) piézoélectrique, dont, par l'une des faces, est collée à un support, au moyen d'une couche adhésive (42),

au moins deux transducteurs constitués de bandes en forme de doigts et prévus sur la seconde face du substrat (2), pour produire des ondes de surface d'un type prescrit, et éventuellement au moins une structure à réflecteurs constituée de bandes formant réflecternrs et adaptée à la réception d'onde du type prescrit, les transducteurs déterminant la direction de propagation principale (x) des ondes, et

en plus, d'autres moyens destinés à enpêcher l'apparition d'ondes de surface réfléchies sinon sur certaines arêtes du substrat,

caractérisé en ce qu'il est prévu, comme autres moyens de ce genre, une structure de conversion (12, 22, 32) qui transforme un type d'onde produit et déterminé à l'avance, et qui, considéré dans la direction de propagation principale (x) des ondes, est disposée dans la partie de cette seconde face du substrat dans laquelle l'apparition d'une onde de surface n'est pas souhaitable, cette structure de conversion (12, 22, 32), en tant que perturbation agissant sur des ondes acoustiques, état constituée d'un certain nombre de bandes (13, 113) qui sont prévues dans ou sur la face du substrat (2), qui s'étendent les unes à côté des autres à un intervalle (P) et la périodicité (P) des bandes (13, 113, 213), mesurée dans la direction de propagation principale des ondes, étant donnée par l'équation :

8

$$\frac{1}{P \cdot f} \quad \text{inférieure à} \quad \frac{1}{V_{SAW}} \quad + \quad \frac{1}{V^*}$$

où f est la limite basse de fréquence de la bande de transmission prévue pour le dispositif à ondes de surface concernée, $V_{SAW}$ est la vitesse de l'onde de surface (SAW) du type d'onde prescrit dans le matériau du substrat (2) et V* est

la vitesse ($V_{max}$) de l'onde de volume créée par la transformation, qui est l'onde de volume du mode d'onde ayant la vitesse du son maximale ($V_{max}$) dans le matériau du substrat (2), ou

la vitesse ($V_{BAW}$) de l'onde de volume créée par la transformation, qui est l'onde de volume la plus lente qui contribue, de manière prépondérante, à l'onde de surface (SAW) du type d'onde déterminé à l'avance, de sorte que les ondes de volume (40) produites dans la structure de conversion (12) à partir d'ondes de surface appparaissant de manière indésirable, arrivent dans la zone du produit adhésif (12) à amortissement non élastique.

2. Dispositif à ondes de surface selon la revendication 1, caractérisé en ce que, lors de l'excitation d'une onde de surface (SAW) du type Onde de Rayleigh, la vitesse ($V_{BAW}$) est la vitesse de l'onde (quasi)-transversale polarisée verticalement.

3. Dispositif à ondes de surface selon la revendication 1, caractérisé en ce que, lors de l'excitation d'une onde de surface (SAW) du type Onde de Rayleigh, la vitesse ($V_{BAW}$) est la vitesse de l'onde de volume polarisée horizontalement.

4. Dispositif à ondes de surface selon la revendication 1, 2 ou 3, caractérisé en ce que la structure de conversion (12, 22, 32) est en un matériau déposé de manière structurée sur la face du substrat.

5. Dispositif à ondes de surface selon la revendication 4, caractérisé en ce que ce matériau n'est pas conducteur électriquement.

6. Dispositif à ondes de surface selon la revendication 4 ou 5, caractérisé en ce que ce matériau est un oxyde métallique.

7. Dispositif à ondes de surfaces selon la revendication 4, caractérisé en ce que le matériau est du métal.

8. Dispositif à ondes de surface selon la revendication 1 ou 3, caractérisé en ce que la structure de conversion est une structure creusée dans la surface.

9. Dispositif à ondes de surface selon la revendication 8, caractérisé en ce que la structure creusée est une structure gravée.

10. Dispositif à ondes de surface selon la revendication 9, caractérisé en ce que les bandes sont à peu près orthogonales à la direction de propagation principale des ondes du transducteur et/ou de la structure à réflecteurs.

11. Dispositif à ondes de surface selon la revendication 9, caractérisé en ce que les bandes sont sensiblement inclinées par rapport à la direction de propagation principale des ondes du transducteur et/ou de la structure à réflecteurs.

12. Dispositif à ondes de surface selon l'une des revendications 1 à 9, caractérisé en ce que les bandes (213) sont incurvées.

13. Dispositif à ondes de surface selon la revendication 9, 10 ou 11, caractérisé en ce que les bandes (113) sont interrompues de manière à avoir des points se succédant dans la direction des bandes.

**14.** Dispositif à ondes de surface selon l'une des revendications 9 à 12, caractérisé en ce que les bandes sont équidistantes.

EP 0 386 009 B1

FIG 1

FIG 2

11

## FIG 3

## FIG 4